# EUROPEAN PATENT APPLICATION

(11) **EP 2 587 489 A1**
(43) Date of publication of application: **01.05.2013**
(21) Application number: 12188620.4
(22) Date of filing: 16.10.2012
(51) Int. Cl.: G11C 29/56, G11C 29/08

(54) **Systems and methods for testing memories**

(30) Priority: 27.10.2011 CN 201110332054; 01.10.2012 US 201213632680
(71) Applicant: Maishi Electronic (Shanghai) Ltd., Zhang Jiang Hi-Tech Park Shanghai 201203 (CN)
(72) Inventor: Zhang, Weihua, 610041 Chengdu (CN); Yu, Mei, 610041 Chengdu (CN)
(74) Representative: Lippert, Stachow & Partner

(57) **Abstract**

A system for testing a plurality of memories includes a plurality of memory testing devices and a controller. Each of the memory testing devices is coupled to one of the memories. The controller is configured to generate a test vector and send the test vector to the memory testing devices. Each of the memory testing devices tests its coupled memory respectively according to the test vector and sends a test result to the controller.

## Description

### RELATED APPLICATION

This Application claims priority to Chinese Patent Application Number 201110332054.4, filed on October 27, 2011 with State Intellectual Property Office of P.R. China (SIPO), which is hereby incorporated by reference.

### FIELD OF THE PRESENT TEACHING

The present teaching relates to a memory technology, and more particularly to a system and a method for testing memories.

### BACKGROUND

In order to ensure memories to store data properly and operate normally without errors while storing data, it is needed to test the memories. Conventionally, a built-in self test (BIST) technology is adopted to test memories. Each BIST circuit is corresponding to a memory and is responsible for testing the corresponding memory. As the BIST circuits of the memories are independent from each other, different logic circuits are needed in order to test different memories. Therefore, quite a few logic circuits are required for testing multiple memories using the conventional technology. This increases the chip size and manufacturing cost.

### SUMMARY

The present teaching relates to a memory technology, and more particularly to a system and a method for testing memories.

In one embodiment, a system for testing a plurality of memories is provided. The system includes a plurality of memory testing devices and a controller. Each of the memory testing devices is coupled to one of the memories. The controller is configured to generate a test vector and send the test vector to the memory testing devices. Each of the memory testing devices tests its coupled memory according to the test vector and sends a test result to the controller.

In another embodiment, a method for testing a plurality of memories is provided. A test vector is generated. The test vector is sent to multiple memory testing devices. Each of the memory testing devices is coupled to one of the memories respectively, and tests its coupled memory according to the test vector. Multiple test results are received from the memory testing devices.

### BRIEF DESCRIPTION OF THE DRAWINGS

Features and advantages of embodiments of the claimed subject matter will become apparent as the following detailed description proceeds, and upon reference to the drawings, wherein like numerals depict like parts. These exemplary embodiments are described in detail with reference to the drawings. These embodiments are non-limiting exemplary embodiments, in which like reference numerals represent similar structures throughout the several views of the drawings.

FIG. 1 illustrates a schematic diagram of a system for testing memories, in accordance with an embodiment of the present teaching;

FIG. 2 illustrates a detailed schematic diagram of a system for testing memories, in accordance with an embodiment of the present teaching;

FIG. 3 illustrates a timing diagram of the read operation and the write operation performed by a controller on multiple memories, in accordance with an embodiment of the present teaching;

FIG. 4 shows a flowchart of operations performed by a system for testing memories, in accordance with an embodiment of the present teaching; and

FIG. 5 shows a flowchart of operations performed by a system for testing memories, in accordance with an embodiment of the present teaching.

### DETAILED DESCRIPTION

Reference will now be made in detail to the embodiments of the present teaching. While the present teaching will be described in conjunction with these embodiments, it will be understood that they are not intended to limit the present teaching to these embodiments. On the contrary, the present teaching is intended to cover alternatives, modifications and equivalents, which may be included within the spirit and scope of the present teaching as defined by the appended claims.

Furthermore, in the following detailed description of the present teaching, numerous specific details are set forth in order to provide a thorough understanding of the present teaching. However, it will be recognized by one of ordinary skill in the art that the present teaching may be practiced without these specific details. In other instances, well known methods, procedures, components, and circuits have not been described in detail as not to unnecessarily obscure aspects of the present teaching.

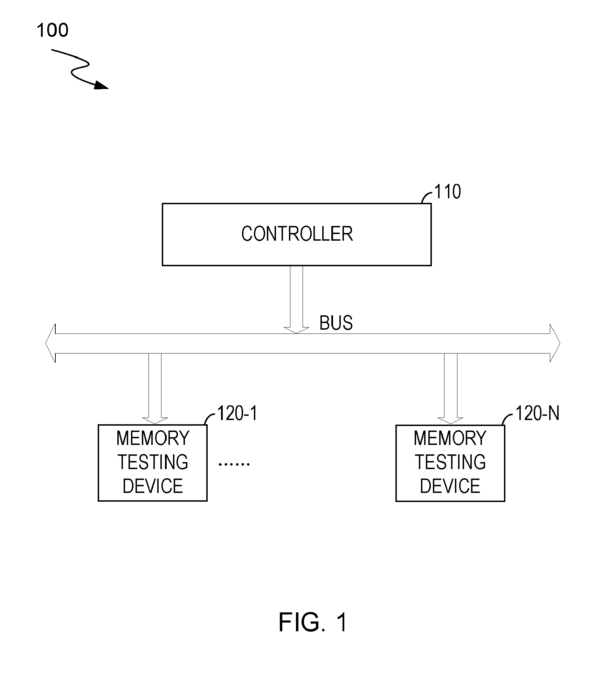

FIG. 1 illustrates a schematic diagram of a system for testing memories, in accordance with an embodiment of the present teaching. As shown in FIG. 1, the system 100 includes a controller 110 and multiple memory testing devices 120-1 through 120-N. It is assumed that the number of the memories and the number of the memory testing devices are N (N is an integer and is greater than one). And it should be understood that N is not a limitation to the embodiment of the present teaching.

In one embodiment, the controller 110 is coupled to the memory testing devices 120-1 through 120-N via a bus. The controller 110 generates a test vector and sends the test vector via the bus to the memory testing devices 120-1 through 120-N. Each of the memory testing devices 120-1 through 120-N tests a corresponding memory according to the test vector and sends a corresponding result to the controller 110. For example, the memory testing device 120-1 tests a corresponding memory according to the test vector, generates a test result and sends the test result to the controller 110.

In one embodiment, the test vector includes a test address and test data. A high-speed clock signal can be used to control the controller 110 to generate the test address and the test data included in the test vector. As a result, all the memory testing devices 120-1 through 120-N have the same read/write timing. Therefore, the drawback of inconsistent test timings as in the conventional technology caused by different test circuits adopted by the memories can be avoided. Thus, it is convenient to manage the test timings of the memory testing devices.

As shown in FIG. 1, a test vector generated by the controller 110 is used to test a memory which is corresponding to a memory testing device. Thus, there is no need to have a BIST circuit for each memory as in the conventional technology. Therefore, the control logic circuits needed for testing multiple memories are minimized, and the die size of the chip for manufacturing the control logic circuits is decreased. Moreover, the hardware cost can be significantly reduced.

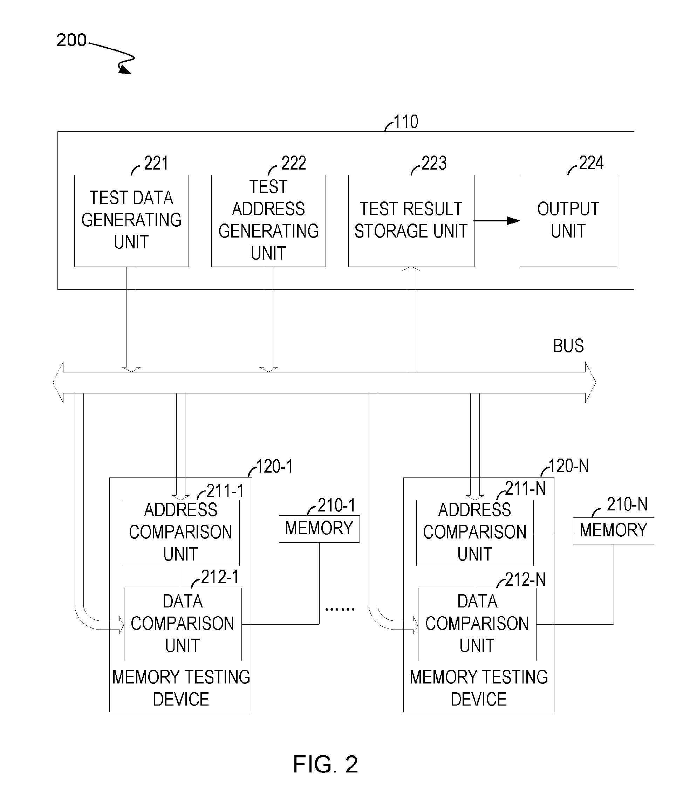

FIG. 2 shows a detailed diagram of a system 200 for testing memories, in accordance with an embodiment of the present teaching. Elements having similar functions as in FIG. 1 are labeled the same and will not be repetitively described herein for purposes of brevity and clarity.

As shown in FIG. 2, each of the memory testing devices 120-1 through 120-N is coupled to a corresponding memory. For example, the memory testing device 120-1 is coupled to a corresponding memory 210-1, and the memory testing device 120-N is coupled to a corresponding memory 210-N. Each of the memory testing devices 120-1 through 120-N further includes an address comparison unit and a data comparison unit. For example, the memory testing device 120-1 includes an address comparison unit 211-1 and a data comparison unit 212-1, and the memory testing device 120-N includes an address comparison unit 211-N and a data comparison unit 212-N.

The controller 110 includes a test data generating unit 221, a test address generating unit 222, a test result storage unit 223 and an output unit 224. Moreover, each of the data comparison units 212-1 through 212-N is coupled to the test data generating unit 221 through a data bus in the bus, and each of the address comparison units 211-1 through 211-N is coupled to the test address generating unit 222 through an address bus in the bus.

In one embodiment, the controller 110 generates a test vector including a test address, test data, a read command, a write command and so on. As shown in FIG. 2, the test data generating unit 221 of the controller 110 generates the test data which needs to be written into the memories 210-1 through 210-N according to a predetermined algorithm, and broadcasts the test data to the memory testing devices 120-1 through 120-N via the bus. The test address generating unit 222 of the controller 110 generates the test address and broadcasts the test address to the memory testing devices 120-1 through 120-N via the bus.

More specifically, the test data generating unit 221 generates the test data based on the maximum capacity among the capacities of the memories 210-1 through 210-N which are corresponding to the memory testing devices 120-1 through 120-N, respectively. For example, if the maximum capacity among the capacities of the memories 210-1 through 210-N is 32 bits, the controller 110 generates the test data based on the 32 bits, so as to test all the memories 210-1 through 210-N. The test address generating unit 222 generates the test address based on the maximum address among the addresses of the memories 210-1 through 210-N which are corresponding to the memory testing devices 120-1 through 120-N. For example, if the maximum address among the addresses of the memories 210-1 through 210-N is 0fff, the generated test address should not exceed the maximum address 0fff, so that all the memories 210-1 through 210-N may be accessed.

The memory testing devices 120-1 through 120-N receive the test data and the test address from the controller 110. Specifically, take the memory testing device 120-1 for example. The address comparison unit 211-1 of the memory testing device 120-1 compares the test address from the controller 110 with the maximum address of the memory 210-1 that is corresponding to the memory testing device 120-1. If the test address is within the maximum address range of the memory 210-1, the test data is written into a storage unit with the test address in the memory 210-1 and the data comparison unit 212-1 according to the write command in the test vector. For example, if the test address is 0001, and the maximum address of the memory 210-1 is 0fff. Then the test address is within the maximum address range which is from 0000 to 0fff. Therefore, the test data is written into the storage unit with the test address 0001 in the memory 210-1 and the comparison unit 212-1 according to the write command in the test vector.

The data comparison unit 212-1 reads the test data written into the storage unit with the test address in the memory 210-1 according to the read command in the test vector, compares the data read from the memory 210-1 with the test data written into the data comparison unit 212-1, and generates a test result. Specifically, if the data read from the memory 210-1 is equal to the test data written into the data comparison unit 212-1 by the controller 110, the data comparison unit 212-1 sets the test result to a first logic state, otherwise, the data comparison unit 212-1 sets the test result to a second logic state.

On the other hand, if the test address from the controller 110 exceeds the maximum address range of the memory 210-1 which is corresponding to the memory testing device 120-1, no action will be performed on the memory 210-1. That is, the address comparison unit 211-1 does not perform the write operation in response to the write command in the test vector and the data comparison unit 212-1 does not perform the read operation or the data comparison operation.

More specifically, the first logic state can be logic high and the second logic state can be logic low, or the first logic state can be logic low and the second logic state can be logic high. In the present teaching, the first and the second logic state are not limited. And the test operations performed by the other memory testing devices 120-2 through 120-N are similar to the test operation performed by the memory testing device 120-1 as illustrated above, and will not be repetitively described here for the purposes of clarity and brevity.

The test result storage unit 223 of the controller 110 receives the test results from the memory testing devices 120-1 through 120-N via the bus, and stores the received test results. The test results are output by the output unit 224. More specifically, the storage capacity of the result storage unit 223 is determined by the number of the memory testing devices, which is an integer N. The data comparison units 212-1 through 212-N of the memory testing devices 120-1 through 120-N send the test results to the test result storage unit 223 of the controller 110 in parallel when triggered by the clock signal. The test result storage unit 223 stores each of the received test results in a corresponding position based on a predetermined position arrangement. Because the test result storage unit 223 stores the received test results based on the predetermined position arrangement, the users can find out one or more faulty memories among the memories 210-1 through 210-N which are corresponding to the received test results respectively by detecting the received test results output by the output unit 224.

Moreover, the storage capacity of the test result storage unit 223 is determined by the number of the memory testing devices which is an integer N. Each of the memory testing devices 120-1 through 120-N sends the corresponding test result to a corresponding storage position in the test result storage unit 223 in parallel via the bus.

For example, the test result is in the first logic state (logic 1) when the corresponding memory is normal while the test result is in the second logic state (logic 0) when the memory is faulty. If the Mth memory 210-M which is corresponding to the Mth memory testing device 120-M is faulty (e.g., the Mth memory 210-M can't read data normally), the test results are 1 (the 1 st), ..., 1, ..., 0(the Mth), ..., and 1 (the Nth). The test result storage unit 223 stores the test results in the predetermined positions (e.g., the test results are stored in sequential). The test results and the corresponding storage positions of the test result storage unit 223 are shown in Table 1.

**TABLE 1**

| | | | | | | | |
|---|---|---|---|---|---|---|---|
| storage positions | 1 | 2 | ... | M | ... | N-1 | N |
| test results | 1 | 1 | 1 | 0 | 1 | 1 | 1 |

The test results are sequentially stored in the test result storage unit 223 and sequentially output by the output unit 24. The test result of the Mth memory 210-M is zero, therefore according to the test results, the Mth memory 210-M is determined to be faulty and can't store data normally. The faulty Mth memory which can't store data normally is just taken as an example. It should be noted that there may also be more than one memory, which can be tested by the memory testing devices 120-1 through 120-N, failing to store data normally. The detailed description is omitted herein for purposes of brevity and clarity.

It should be understood that the above Table 1 is merely an illustrative description of the test result storage unit 223 storing the test results. One of ordinary skill in the art should understand that the test result storage unit 223 can store data in a matrix form when a large number of memories need to be tested. For example, when storing test results of 1024 bits, the test result storage unit 223 can store the test results in a 32x32 matrix form in predetermined positions, which is much more effective than storing the 1024 bits in line and is much more convenient to implement.

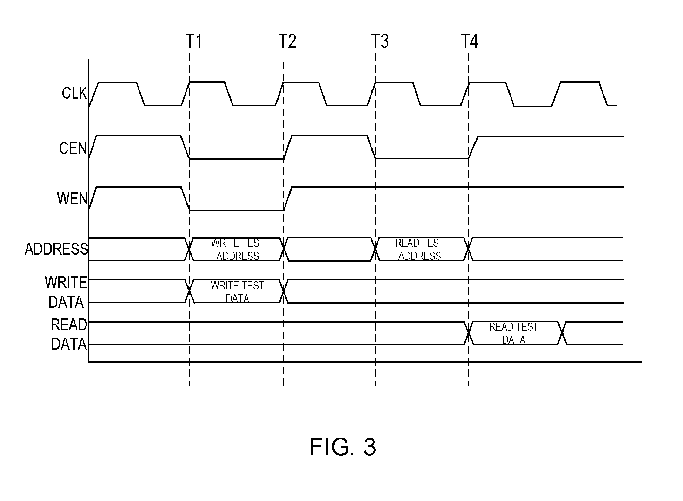

FIG. 3 shows a timing diagram of the read operation and the write operation performed by a controller on multiple memories, in accordance with an embodiment of the present teaching. In one embodiment, take multiple single-port memories for example. The read operation and the write operation on the multiple memories in FIG. 3 are described in connection with FIG. 2, according to one embodiment of the present teaching.

The test data generating unit 221 and the test address generating unit 222 of the controller 110 generate the test data and the test address respectively under the control of a clock signal (CLK) according to a predetermined algorithm (e.g., the predetermined algorithm can be March C+). As shown in FIG. 3, the controller 110 sends a chip select enable signal (CEN) and a write enable signal (WEN) to the memories 210-1 through 210-N which are corresponding to the memory testing devices 120-1 through 120-N respectively. When the first rising edge of the CLK signal is coming at time T1, both the chip select enable signal CEN and the write enable signal WEN drop from logic high to logic low, and the controller 110 provides the test address and the test data which is then written into the storage unit with the test address in each of the memories 210-1 through 210-N.

When the second rising edge of the CLK signal is coming at time T2, the chip select enable signal CEN and the write enable signal WEN rise from logic low to logic high. The read operation and the write operation on the memories 210-1 through 210-N are terminated.

When the third rising edge of the CLK signal is coming at time T3, the chip select enable signal CEN drops from logic high to logic low while the write enable signal WEN maintains a logic high state, the controller 110 provides a read operation address.

When the fourth rising edge of the CLK signal is coming at time T4, each of the memory testing devices 120-1 through 120-N accesses the storage unit with the test address in the corresponding memory, thus, the test data stored in the storage unit is obtained.

One of ordinary skill in the art should understand that the controller 110 can provide the read operation address at the second rising edge of the CLK signal. And each of the memory testing devices accesses the storage unit with the test address in the corresponding memory according to the read operation address, that is, data can be read from or written into the memory at continuous timings. Therefore, the test time can be saved.

FIG. 3 is an illustrative example. One of ordinary skill in the art should understand that in a digital circuit, the CLK signal can be used to implement timing control of the digital circuit, therefore, data and address can be read from and write into the memories.

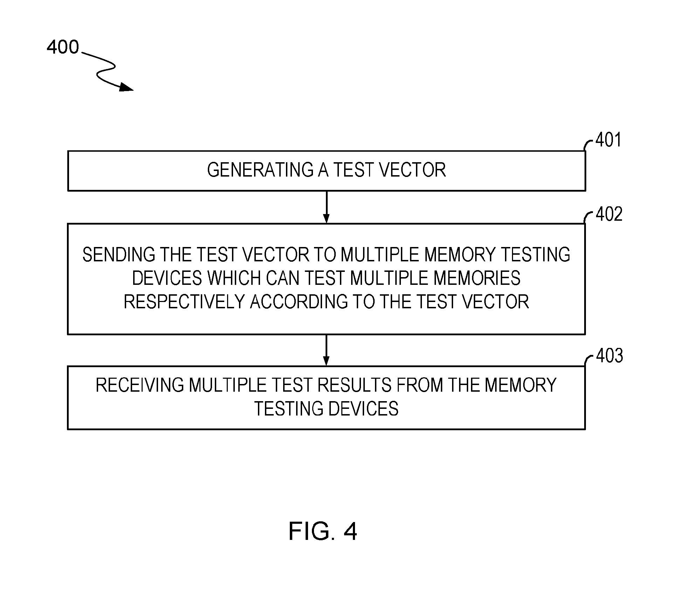

FIG. 4 shows a flowchart of operations performed by a system for testing memories, in accordance with an embodiment of the present teaching. The method for testing memories illustrated in the embodiments of the present teaching can be implemented by the system illustrated in FIG. 1 and FIG. 2. And FIG. 4 is described in connection with FIG. 2.

At 401, a controller 110 generates a test vector. In one embodiment, the test vector includes a test address and test data, etc.

At 402, the controller 110 sends the test vector to multiple memory testing devices 120-1 through 120-N which can test multiple corresponding memories 210-1 through 210-N respectively according to the test vector.

At 403, the controller 110 receives the multiple test results from the memory testing devices 120-1 through 120-N.

As shown in FIG. 4, a test vector generated by the controller 110 is used to test a memory which is corresponding to a memory testing device. Thus, the requirement of one BIST circuit for each memory as in the conventional technology is avoided. Therefore, the control logic circuits required for testing memories are minimized, and the die size of the chip for manufacturing the control logic circuits is decreased. Moreover, the hardware cost can be significantly reduced.

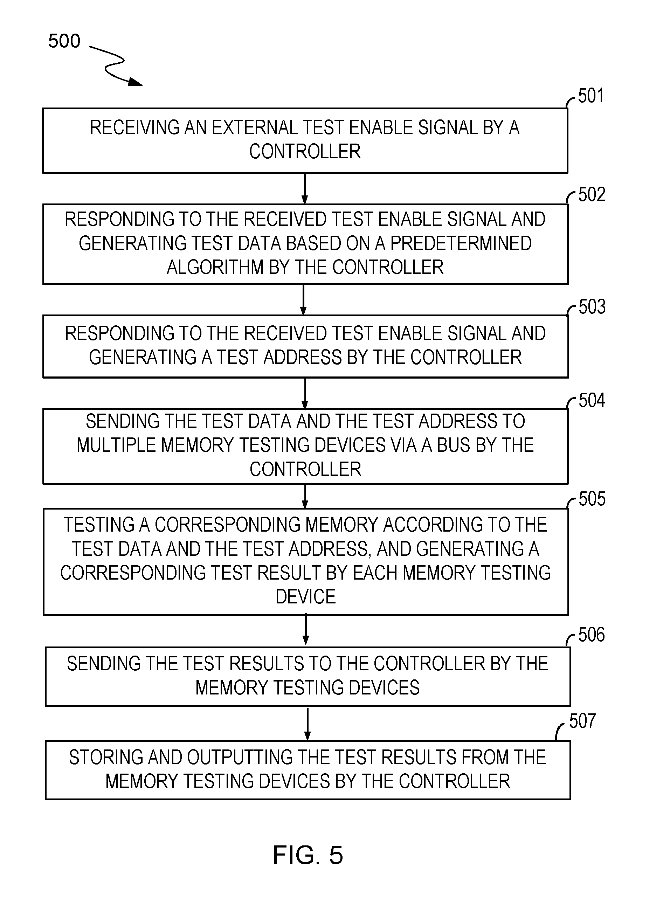

FIG. 5 shows a flowchart of operations performed by a system for testing memories, in accordance with an embodiment of the present teaching. The method illustrated in FIG. 5 can be implemented by the system illustrated in FIG. 1 and FIG. 2. FIG. 5 is now described in connection with FIG. 2.

At 501, a controller 110 receives an external test enable signal. At 502, the controller 110 responds to the received test enable signal and generates test data in a test vector based on a predetermined algorithm. At 503, the controller 110 responds to the received test enable signal and generates a test address in the test vector. At 504, the controller 110 sends the test data and the test address to the memory testing devices 120-1 through 120-N via a bus.

At 505, each of the memory testing devices 120-1 through 120-N tests a corresponding memory according to the test data and the test address, and generates a corresponding test result. At 506, the memory testing devices 120-1 through 120-N send the multiple test results to the controller 110. In one embodiment, the test results are sent to the controller 110 in parallel. At 507, the controller 110 stores and outputs the test results from the memory testing devices 120-1 through 120-N.

More specifically, at 501, the test enable signal can be a triggering signal which can trigger the controller 110 to test the memories 210-1 through 210-N which are corresponding to the memory testing devices 120-1 through 120-N.

At 502, the controller 110 generates the test vector according to March C+ algorithm. The read operation and the write operation performed on single-port memories according to the generated test vector are shown in FIG. 4, and the repetitive description is omitted here for purposes of brevity and clarity. Furthermore, in order to write the test data into the memories 210-1 through 210-N which are corresponding to the memory testing devices 120-1 through 120-N, the test data is generated according to the maximum capacity among the capacities of the memories.

At 503, in order to implement the read operation and the write operation on the memories 210-1 through 210-N, the test address is generated according to the maximum address among the addresses of the memories 210-1 through 210-N.

Furthermore, the controller 110 can perform the foregoing steps 502 and 503 under the same clock signal, and send the test data and the test address to the memory testing devices 120-1 through 120-N via the bus when triggered by the same clock signal.

At 505, each memory testing device compares the test address with the maximum address of the corresponding memory, and write the test data included in the received test vector into the storage unit with the test address in the corresponding memory and the data comparison unit 212-1 when the test address is within the maximum address range of the corresponding memory. Each memory testing device reads the test data having been written into the storage unit according to a read command, compares the data read from the storage unit with the test data having been written into the data comparison unit 212-1 and generates the corresponding test result. When the data read from the storage unit is equal to the test data written into the data comparison unit 212-1, the test result is set to a first logic state, otherwise the test result is set to a second logic state.

On the other hand, when the test address exceeds the maximum address range of a memory, no action will be performed on the memory. Specifically, neither write operation nor read operation is performed on the memory.

At 507, the controller 110 can store the received test results in predetermined positions. When the test results are output by the controller 110, a user can detect which memory is faulty among the memories tested by the memory testing devices 120-1 through 120-N according to the output test results. Furthermore, the controller 110 can output the test results in serial.

As shown in FIG. 5, a test vector generated by the controller 110 is used to test a memory which is corresponding to a memory testing device. Thus, the requirement of one BIST circuit for each memory as in the conventional technology is avoided. Therefore, the control logic circuits required for testing memories are minimized, and the die size of the chip for manufacturing the control logic circuits is decreased. Moreover, the hardware cost can be significantly reduced.

Furthermore, the memories in the present teaching can be single-port static random access memory (SRAM), single-port RAM, dual-port SRAM, dual-port RAM, single-port register file and dual-port register file, etc. One of ordinary skill in the art should understand that each of the memory testing devices can select a storage unit in the corresponding memory according to the test address by specific hardware circuits such as line latches, column latches and decoding circuits. There is no limitation on how to design the memory testing devices by specific hardware circuits in the present teaching.

While the foregoing description and drawings represent embodiments of the present teaching, it will be understood that various additions, modifications and substitutions may be made therein without departing from the spirit and scope of the principles of the present teaching as defined in the accompanying claims. One skilled in the art will appreciate that the teaching may be used with many modifications of form, structure, arrangement, proportions, materials, elements, and components and otherwise, used in the practice of the teaching, which are particularly adapted to specific environments and operative requirements without departing from the principles of the present teaching. The presently disclosed embodiments are therefore to be considered in all respects as illustrative and not restrictive, the scope of the teaching being indicated by the appended claims and their legal equivalents, and not limited to the foregoing description.

## Claims

1. A system for testing a plurality of memories, comprising:
a plurality of memory testing devices, each of which is coupled to one of said memories, respectively; and
a controller, configured to generate a test vector and send said test vector to said memory testing devices,
wherein each of said memory testing devices tests its coupled memory according to said test vector, and sends a test result to said controller.

2. The system of claim 1, wherein said test vector comprises test data and a test address, and wherein said test address comprises a read operation address and a write operation address for a storage unit in each of said memories.

3. The system of claim 1 or 2, wherein said controller comprises:
a test data generating unit, configured to generate said test data according to a predetermined algorithm and send said test data to said memory testing devices via a bus, wherein said test data is written into said memories which are coupled to said memory testing devices respectively; and
a test address generating unit, configured to generate said test address and send said test address to said memory testing devices via said bus.

4. The system of claim 3, wherein said test data generating unit generates said test data according to a maximum capacity among a plurality of capacities of said memories which are coupled to said memory testing devices respectively.

5. The system of claim 3 or 4, wherein said test address generating unit generates said test address according to a maximum address among a plurality of addresses of said memories which are coupled to said memory testing devices respectively.

6. The system of one of claims 1 to 5, wherein said test vector comprises at least one of a read command and a write command.

7. The system of claim 6, wherein each of said memory testing devices comprises an address comparison unit and a data comparison unit, wherein:
said address comparison unit is configured to compare said test address from said controller with a maximum address of a memory corresponding to said each memory testing device, and write said test data in said test vector into said data comparison unit and a storage unit with said test address in said memory according to said write command when said test address is within a maximum address range of said memory; and
said data comparison unit is configured to read said test data written into said storage unit according to said read command, compare said data read from said storage unit with said test data written into said data comparison unit, and generate a test result.

8. The system of claim 7, wherein said address comparison unit is coupled to said test address generating unit via an address bus in a bus, and wherein said data comparison unit is coupled to said test data generating unit via a data bus in said bus.

9. The system of claim 7 or 8, wherein said data comparison unit sets said test result to a first logic state if said data read from said storage unit is equal to said test data written into said data comparison unit, and wherein said data comparison unit sets said test result to a second logic state if said data read from said storage unit is not equal to said test data written into said data comparison unit.

10. The system of one of claims 1 to 9, wherein said controller further comprises:
a test result storage unit, configured to store test results from said memory testing devices respectively; and
an output unit, coupled to said test result storage unit, configured to output said test results to determine if a memory corresponding to each of said memory testing devices is faulty based on said test results.

11. The system of claim 10, wherein a storage capacity of said test result storage unit is determined according to the number of said memory testing devices, and wherein said memory testing devices send, in parallel via a bus, said test results to storage positions which are corresponding to said test results respectively in said test result storage unit.

12. A method for testing a plurality of memories, comprising the steps of:
generating a test vector;
sending said test vector to multiple memory testing devices, wherein each of said memory testing devices is coupled to one of said memories and tests the coupled memory according to said test vector; and
receiving multiple test results from said memory testing devices.

13. The method of claim 12, wherein said test vector comprises test data and a test address, and wherein said test address comprises a read operation address and a write operation address for a storage unit in each of said memories.

14. The method of claim 13, wherein said step of generating said test vector further comprising:
generating said test data according to a predetermined algorithm, wherein said test data is written into said memories which are coupled to said memory testing devices respectively;
generating said test address; and
sending said test data and said test address to said memory testing devices via a bus.

15. The method of claim 14, wherein said step of generating said test data according to a predetermined algorithm further comprising:
generating said test data according to a maximum capacity among a plurality of capacities of said memories which are coupled to said memory testing devices respectively.

16. The method of claim 14 or 15, wherein said step of generating said test address comprising:
generating said test address according to a maximum address among a plurality of addresses of said memories which are coupled to said memory testing devices respectively.

17. The method of one of claims 13 to 16, wherein said memory testing devices test said multiple memories according to said test vector by performing the steps of:
comparing said test address with a maximum address of a memory which is corresponding to each memory testing device by an address comparison unit in said each memory testing device;
writing said test data in said test vector into a data comparison unit in said each memory testing device and a storage unit with said test address in said memory when said test address is within a maximum address range of said memory;
reading said test data written into said storage unit according to a read command in said test vector;
comparing data read from said storage unit with said test data written into said data comparison unit by said data comparison unit; and
generating a test result according to a comparison of said data read from said storage unit with said test data written into said data comparison unit.

18. The method of claim 17, wherein said step of generating said test result according to a comparison of said data read from said storage unit with said test data written into said data comparison unit, comprising:
setting said test result to a first logic state if said data read from said storage unit is equal to said test data written into said data comparison unit; and
setting said test result to a second logic state if said data read from said storage unit is not equal to said test data written into said data comparison unit.

19. The method of one of claims 12 to 18, further comprising:
storing said test results in multiple predetermined positions of said controller.
